(19) Europäisches Patentamt
European Patent Office
Office européen des brevets

(11) EP 2 997 661 B1

(12) **FASCICULE DE BREVET EUROPEEN**

(45) Date de publication et mention
de la délivrance du brevet:
**13.12.2017 Bulletin 2017/50**

(21) Numéro de dépôt: **14725079.9**

(22) Date de dépôt: **13.05.2014**

(51) Int Cl.:
*H03B 5/04* (2006.01)     *H03B 5/32* (2006.01)
*H03L 7/00* (2006.01)     *H03L 1/02* (2006.01)

(86) Numéro de dépôt international:
**PCT/EP2014/059763**

(87) Numéro de publication internationale:
**WO 2014/184191 (20.11.2014 Gazette 2014/47)**

(54) **DISPOSITIF ET PROCÉDÉ DE RECALAGE D'UNE FRÉQUENCE D'OSCILLATION D'UN OSCILLATEUR VCTCXO**

VORRICHTUNG UND VERFAHREN ZUR NEUTAKTUNG EINES OSZILLATIONSFREQUENZ EINES VCTCXO-OSZILLATORS

DEVICE AND METHOD FOR RETIMING AN OSCILLATION FREQUENCY OF A VCTCXO OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2013 FR 1354341**

(43) Date de publication de la demande:
**23.03.2016 Bulletin 2016/12**

(73) Titulaire: **SAGEMCOM BROADBAND SAS 92500 Rueil Malmaison (FR)**

(72) Inventeurs:
• **DONNENWIRTH, Freddy**
  **92500 Rueil Malmaison (FR)**
• **JOURDAIN, Laurent**
  **92500 Rueil Malmaison (FR)**

(74) Mandataire: **Le Guen-Maillet**
   **5, place de Newquay**
   **BP 70250**
   **35802 Dinard Cedex (FR)**

(56) Documents cités:
**EP-A1- 0 483 090     US-A- 5 875 388**
**US-A1- 2008 218 279**

EP 2 997 661 B1

**EP 2 997 661 B1**

**Description**

La présente invention concerne un recalage d'une fréquence d'oscillation d'un oscillateur contrôlé en tension et compensé en température grâce à une référence temporelle ou fréquentielle externe.

Pour pouvoir cadencer des traitements réalisés par un dispositif, un oscillateur contrôlé en tension et compensé en température VCTCXO (« Voltage-Controlled Temperature-Compensated Crystal Oscillator » en anglais) peut être mis en oeuvre. On retrouve ce type d'oscillateur dans de nombreux équipements de communication.

Un tel exemple est décrit dans EP 0 483 090.

Dans le monde de la téléphonie mobile, une *femtocell* (pour femto-cellule) est une cellule d'un système cellulaire de téléphonie mobile, offrant une couverture radio limitée et généralement dédiée à un usage domestique. La station de base, appelée *femto,* en charge de gérer la femtocell se connecte au réseau de l'opérateur de téléphonie mobile via une passerelle Internet (« Internet gateway » en anglais). De telles femtos disposent typiquement d'un oscillateur de type VCTCXO.

Lorsqu'un dispositif met en oeuvre un oscillateur de type VCTCXO, il peut être nécessaire de faire appel à une référence temporelle ou fréquentielle externe, afin de recaler la fréquence d'oscillation de l'oscillateur et ainsi permettre de respecter la précision en fréquence requise, e.g. +/-250 ppb (« Parts per Billion » en anglais). On notera par exemple les protocoles NTP (« Network Time Protocol » en anglais, tel que défini dans les documents normatifs RFC 1305 et RFC 5905) et PTP («Precision Time Protocol » en anglais, tel que défini par le standard IEEE 1588) permettant de synchroniser la fréquence d'oscillation de l'oscillateur grâce à une référence temporelle externe.

La stabilité en fréquence d'un oscillateur VCTCXO dépend essentiellement de la variation de la température ambiante autour de l'oscillateur et de son vieillissement (« ageng » en anglais). Les variations de température ambiante peuvent être rapides et importantes, *e.g.* plusieurs dizaines de degrés en moins d'une heure, et provoquer, sur une durée de une ou deux heures, les variations de fréquence maximales prévues dans les spécifications de l'oscillateur. Le vieillissement, quant à lui, entraine des variations de fréquence plus faibles et plus lentes, *e.g.* quelques dizaines de ppb sur plusieurs jours, soit approximativement 1 ppm (« Parts per Million » en anglais) sur un an. Les variations de fréquence provoquées par les variations de température ambiante sont donc les plus contraignantes à corriger en termes de fréquence, ou de débit, d'accès à la référence temporelle ou fréquentielle externe.

Pour pouvoir assurer la précision requise de l'oscillateur, il est usuel de définir la fréquence, ou le débit, d'accès à la référence temporelle externe de sorte à pouvoir corriger les variations de fréquence prévisionnelles les plus contraignantes. Cela entraîne un trafic de données important entre le dispositif comportant l'oscillateur et la référence temporelle externe, et réduit le nombre maximum de dispositifs qu'un même serveur de temps peut gérer en parallèle.

Pour limiter la fréquence, ou le débit, d'accès à la référence temporelle externe, il est connu d'utiliser un oscillateur VCTCXO suffisamment stable et/ou pré-calibré en température pour que les échanges avec le serveur de temps en tant que la référence temporelle externe ne soient destinés qu'aux corrections due au vieillissement de l'oscillateur. Cette approche pose cependant un problème de coût de fabrication.

Il est souhaitable de pallier ces inconvénients de l'état de la technique. Il est notamment souhaitable de fournir une solution qui permette de recaler une fréquence d'oscillation d'un oscillateur contrôlé en tension et compensé en température grâce à une référence temporelle externe, tout en préservant les ressources réseau pour accéder à cette référence temporelle externe, ainsi que les ressources de traitement (« processing resources » en anglais) du dispositif implémentant cette référence temporelle externe.

Il est notamment souhaitable de fournir une solution qui soit simple à mettre en oeuvre et à faible coût.

L'invention concerne un procédé de recalage d'une fréquence d'oscillation d'un oscillateur contrôlé en tension et compensé en température d'un dispositif, ledit dispositif accédant à une référence temporelle ou fréquentielle externe pour recaler la fréquence d'oscillation dudit oscillateur en fonction d'informations temporelles ou respectivement fréquentielles fournies par ladite référence temporelle externe. Ledit dispositif comporte un capteur de température et effectue les étapes suivantes : déterminer une variation de température ambiante dudit oscillateur sur une plage temporelle prédéterminée grâce à des mesures dudit capteur ; et ajuster une fréquence, ou un débit, d'accès à la référence temporelle ou fréquentielle externe pour obtenir lesdites informations temporelles ou respectivement fréquentielles pour recaler la fréquence d'oscillation dudit oscillateur, en fonction de la variation de température déterminée. Ainsi, le dispositif sollicite l'accès à la référence temporelle ou fréquentielle externe lorsque la fréquence d'oscillation de l'oscillateur est le plus susceptible d'évoluer, c'est-à-dire lorsque la température ambiante de l'oscillateur varie.

Selon un mode de réalisation particulier, une isolation thermique étant réalisée grâce à un premier capot recouvrant ledit oscillateur sur un circuit imprimé dans lequel des trous sont aménagés autour dudit oscillateur et un deuxième capot recouvrant la face opposée du circuit imprimé, ledit dispositif détermine la variation de température ambiante dudit oscillateur grâce en outre à une fonction de transfert de ladite isolation thermique. Cet agencement entraine un filtrage des variations rapides de la température ambiante de l'oscillateur, ce qui limite la pente des variations de la fréquence d'oscillation de l'oscillateur et introduit un décalage dans le temps. La réduction de la pente de variation de la fréquence d'oscillation de l'oscillateur est directement répercutée sur la fréquence ou le débit d'accès à la référence temporelle ou fréquentielle externe.

Selon un mode de réalisation particulier, la référence temporelle externe est implémentée par un serveur de temps. Ainsi, le recalage de la fréquence d'oscillation de l'oscillateur est facilement réalisable à travers un réseau de communication, tel que l'Internet.

Selon un mode de réalisation particulier, plusieurs niveaux de variation de température ambiante dudit oscillateur étant définis, chaque niveau étant associé à au moins une fenêtre glissante respective, chaque fenêtre glissante étant associée à au moins un seuil de variation de température ambiante permettant de passer d'un niveau à un autre, chaque niveau étant en outre associé à une fréquence ou un débit d'accès à la référence temporelle externe, le dispositif effectue les étapes suivantes : déterminer si la variation de température ambiante sur chaque fenêtre glissante d'un premier niveau de variation de température ambiante franchit un seuil associé à ladite fenêtre glissante ; changer pour un second niveau lorsque ledit seuil est franchi, et appliquer la fréquence ou le débit d'accès à la référence temporelle externe qui est associé(e) audit second niveau. Les modifications de fréquence, ou de débit, d'accès à la référence temporelle externe se font alors par paliers, permettant ainsi de compenser simplement l'inertie du recalage par serveur de temps.

Selon un mode de réalisation particulier, deux fenêtres glissantes sont définies par niveau de variation de température ambiante. Ainsi, les pics de variations de température et les variations de température à long terme peuvent être détectés, et la correction appropriée de fréquence d'oscillation de l'oscillateur peut être apportée.

Selon un mode de réalisation particulier, des niveaux distincts de variation de température ambiante dudit oscillateur sont définis pour un régime transitoire et un régime établi dudit dispositif. Ainsi, le débit d'accès à la référence temporelle externe peut être renforcé pour le régime transitoire, où l'échauffement des composants électroniques entraîne de brusques variations de fréquence d'oscillation de l'oscillateur.

Selon un mode de réalisation particulier, lors d'un passage du premier niveau au second niveau, le dispositif reporte sur chaque fenêtre glissante dudit second niveau une partie des variations de température ambiante détectées pendant chaque fenêtre glissante du premier niveau. Ainsi, l'inertie du recalage par serveur de temps est compensée au changement de niveau.

Selon un mode de réalisation particulier, chaque niveau de variation de température ambiante étant associé à une précision de fréquence d'oscillation dudit oscillateur, le dispositif étant une femto, le dispositif effectue les étapes suivantes : détecter une station de base gérant une cellule voisine à la femtocell gérée par la femto de meilleure précision que celle du niveau de variation de température ambiante dans lequel le dispositif se trouve ; attendre une absence de communications dans la femtocell, puis se mettre en écoute de la station de base pour obtenir les informations fréquentielles pour recaler la fréquence d'oscillation dudit oscillateur. Ainsi, étant donné que surveiller des cellules voisines monopolise la chaîne d'émission-réception de la femto, la station de base est utilisée en assistance du serveur de temps. L'accès, même sporadique, à la station de base soulage les accès au serveur de temps, car l'inertie du recalage par serveur de temps est bien plus grande qu'un recalage par station de base.

Selon un mode de réalisation particulier, le dispositif sélectionne ladite station de base pour recaler la fréquence d'oscillation dudit oscillateur dans chacun des cas suivants : la différence entre la variation de température ambiante déterminée et chaque seuil de variation de température ambiante associé à une fenêtre glissante du niveau de variation de température ambiante dans lequel le dispositif se trouve est inférieure à une marge prédéfinie ; la précision de la station de base est meilleure que la précision correspondant au niveau inférieur de variation de température ambiante par rapport au niveau de variation de température ambiante dans lequel le dispositif se trouve, et la variation de température ambiante déterminée est en-dessous d'un seuil haut de variation de température associé à la ou aux fenêtre(s) glissante(s) dudit niveau inférieur. Cela permet de réduire le débit d'accès à la référence temporelle externe en évitant de passer à un niveau supérieur, ou d'accélérer le passage à un niveau inférieur.

Selon un mode de réalisation particulier, le dispositif effectue les étapes suivantes : traduire la précision de la station de base en une variation de température ambiante correspondante ; et réinitialiser chaque fenêtre glissante et ajouter à chaque fenêtre glissante ladite variation de température ambiante correspondante. Ainsi, il est tenu compte de l'erreur de fréquence potentiellement introduite lors du recalage grâce à la station de base.

Selon un mode de réalisation particulier, ledit dispositif étant une femto, la référence fréquentielle externe est implémentée par une station de base gérant une cellule voisine à la femtocell gérée par la femto. Ainsi, le recalage est rapide.

L'invention concerne également un dispositif comportant un oscillateur contrôlé en tension et compensé en température, le dispositif étant adapté pour accéder à une référence temporelle ou fréquentielle externe et pour recaler la fréquence d'oscillation dudit oscillateur en fonction d'informations temporelles ou respectivement fréquentielles fournies par ladite référence temporelle ou fréquentielle externe. Le dispositif est tel qu'il comporte : un capteur de température ambiante de l'oscillateur ; des moyens pour déterminer une variation de température ambiante dudit oscillateur sur une plage temporelle prédéterminée grâce à des mesures dudit capteur ; et des moyens pour ajuster une fréquence, ou un débit, d'accès à la référence temporelle ou fréquentielle externe pour obtenir lesdites informations temporelles ou respectivement fréquentielles pour recaler la fréquence d'oscillation dudit oscillateur, en fonction de la variation de température déterminée.

Selon un mode de réalisation particulier, le dispositif comporte un circuit imprimé dans lequel des trous sont aménagés autour dudit oscillateur, un premier capot recouvrant ledit oscillateur sur le circuit imprimé et un deuxième capot recouvrant la face opposée du circuit imprimé afin de réaliser une isolation thermique, ledit dispositif comporte des moyens pour déterminer la variation de température ambiante dudit oscillateur grâce en outre à une fonction de transfert de ladite isolation thermique.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1A illustre schématiquement un système de communication dans lequel la présente invention peut être mise en oeuvre ;
- les Figs. 1B et 1C illustrent schématiquement un mode de réalisation d'un dispositif du système de communication ;
- la Fig. 2 illustre schématiquement un exemple d'architecture matérielle dudit dispositif ;
- la Fig. 3 illustre schématiquement un algorithme de recalage de la fréquence d'oscillation d'un oscillateur VCTCXO dudit dispositif ;
- la Fig. 4 illustre schématiquement un algorithme de recalage de la fréquence d'oscillation de l'oscillateur VCTCXO dudit dispositif, reposant sur une utilisation de fenêtres glissantes ;
- la Fig. 5 illustre schématiquement un algorithme complémentaire de recalage de la fréquence d'oscillation d'un oscillateur VCTCXO dudit dispositif, reposant sur une synchronisation avec une station de base ;
- la Fig. 6 illustre schématiquement un algorithme de définition desdites fenêtres glissantes, selon si ledit dispositif est en régime transitoire ou en régime établi.

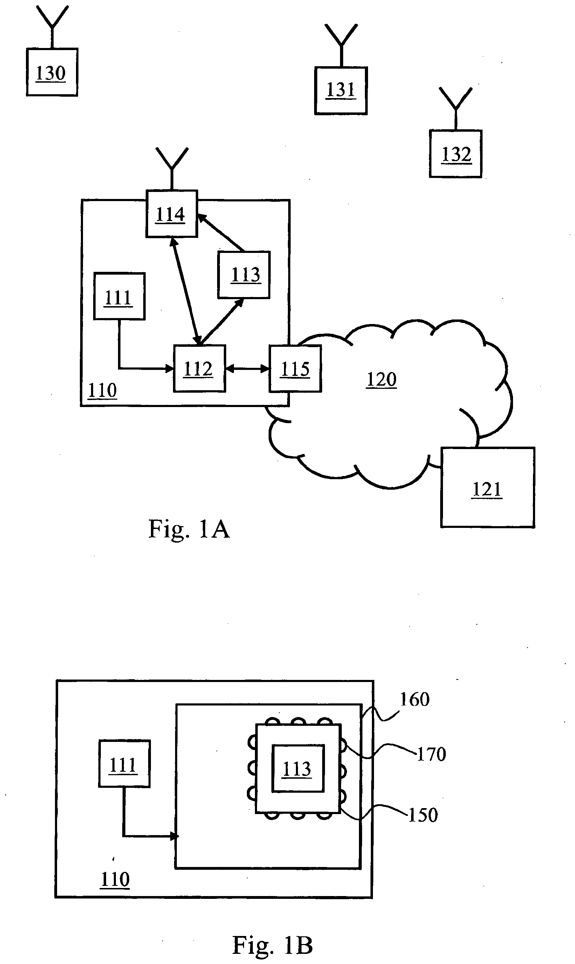

La Fig. 1A illustre schématiquement un système de communication dans lequel la présente invention peut être mise en oeuvre.

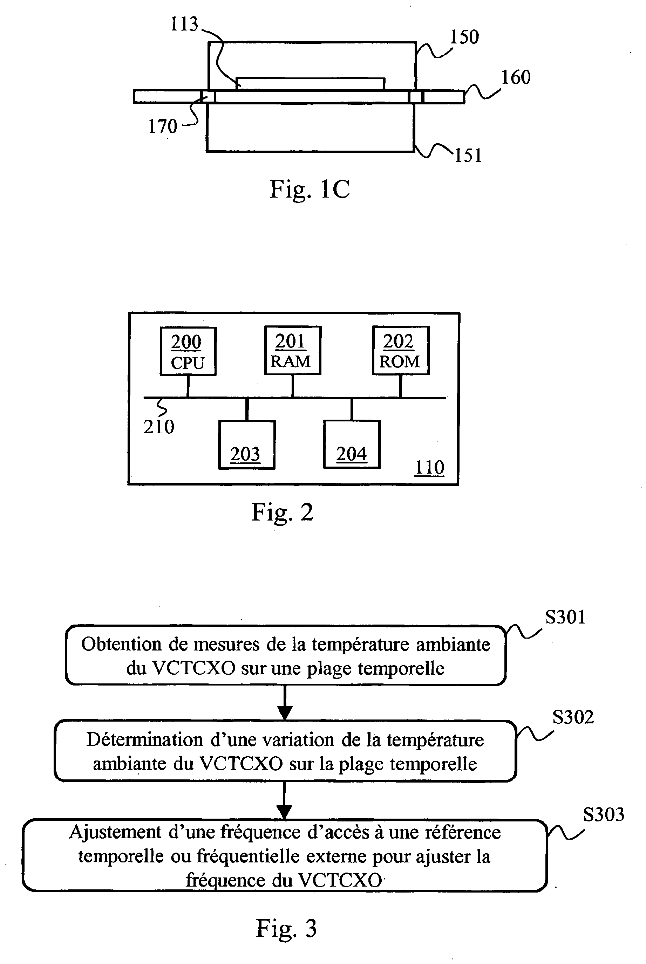

Le système de communication comporte un dispositif 110 comportant un oscillateur VCTCXO 113 pour définir une horloge système propre au dispositif 110, et donc un temps système propre au dispositif 110, et disposant d'au moins une référence temporelle ou fréquentielle externe pour recaler ce temps système et la fréquence d'oscillation de l'oscillateur VCTCXO 113. Une telle référence temporelle ou fréquentielle externe peut être implémentée par un serveur de temps 121 et/ou par une station de base BTS (« Base Transceiver Station » en anglais) 130, comme décrit ci-après en relation avec la Fig. 3.

Dans la description qui suit, le dispositif 110 est plus particulièrement une femto. Toutefois, la mise en oeuvre de l'invention ne se limite pas à ce cadre.

La femto 110 comporte une première interface de communication 115 permettant au dispositif 110 d'échanger des messages et données avec le serveur de temps 121 via un réseau de communication 120, tel que l'Internet. De tels échanges reposent par exemple sur la mise en oeuvre du protocole NTP ou du protocole PTP.

Lorsque la femto 110 utilise le serveur de temps 121 pour déterminer le décalage du temps système de la femto 110, et donc de la fréquence d'oscillation de l'oscillateur VCTCXO 113, par rapport au temps de référence du serveur, chaque calcul de ce décalage temporel est sensible à la latence et à la gigue subies par les messages transmis via le réseau de communication 120. La précision de calcul de l'erreur de fréquence dépendent donc du nombre d'accès effectués auprès du serveur de temps 121, et donc de la fréquence, ou du débit, d'accès à ce serveur de temps 121. Ceci implique une certaine inertie du recalage, par serveur de temps, de la fréquence d'oscillation de l'oscillateur VCTCXO 113.

La femto 110 comporte une seconde interface de communication 114 permettant au dispositif 110 d'échanger des messages et données avec des équipements mobiles UEs (« User Equipment » en anglais) 131, 132, au sein de la femtocell gérée par la femto 110.

La seconde interface de communication 114 est pilotée par une horloge dérivée de l'oscillateur VCTCXO 113. L'oscillateur VCTCXO 113 est contrôlé en tension par un module de contrôle 112 de la femto 110. Le module de contrôle 112 est en outre adapté pour recevoir des données de mesure de température ambiante de l'oscillateur VCTCXO 113 en provenance d'un capteur de température 111. Dans le cadre de la Fig. 1A, le capteur de température 111 est placé dans un même boîtier que l'oscillateur VCTCXO 113 afin d'en mesurer la température ambiante.

Les Figs. 1B et 1C illustrent schématiquement un mode de réalisation de la femto 110, dans lequel un premier capot 150 recouvre l'oscillateur VCTCXO 113 sur un circuit imprimé PCB (« Printed Circuit Board » en anglais) 160 et un deuxième capot 151 recouvre la face opposée du circuit imprimé. Des trous 170 sont préférentiellement aménagés dans le circuit imprimé PCB autour de l'oscillateur VCTCXO 113 afin d'isoler l'oscillateur VCTCXO 113 des variations de températures du circuit imprimé PCB 160 provoquées par les autres composants de la femto 110. Un tel agencement se comporte comme un filtre passe-bas vis-à-vis des variations de la température. Ceci entraine un filtrage des variations rapides de température, mesurées par le capteur de température 111, avec un décalage dans le temps et une réduction de la pente de telles variations. Un tel agencement a donc un effet d'isolation thermique. La fonction de transfert de cette isolation thermique pouvant être connue, e.g. de manière empirique au moyen de tests en laboratoire, il est possible de prédire les variations de température à l'intérieur du capot 150 autour de l'oscillateur VCTCXO 113.

Comme présenté sur les Figs. 1B et 1C, les trous 170 peuvent être aménagés sur le circuit imprimé PCB de sorte à permettre de fixer les premier 150 et second 151 capots sur le circuit imprimé PCB grâce à des éléments de fixation passant par ces trous 170.

La Fig. 2 illustre schématiquement un exemple d'architecture matérielle de la femto 110. La femto 110 comporte alors, reliés par un bus de communication 210 : un processeur ou CPU (« Central Processing Unit » en anglais) 200 ; une mémoire vive RAM (« Random Access Memory» en anglais) 201 ; une mémoire morte ROM (« Read Only Memory » en anglais) 202 ; une unité de stockage ou un lecteur de support de stockage, tel qu'un lecteur de cartes SD (« Secure Digital » en anglais) ou un disque dur HDD (« Hard-Disk Drive » en anglais) 203 ; et un ensemble d'interfaces 204 constitué des première 115 et seconde 114 interfaces de communication. L'oscillateur VCTCXO 113 est par exemple mis en oeuvre dans l'ensemble d'interfaces 204.

Le processeur 200 est capable d'exécuter des instructions chargées dans la RAM 201 à partir de la ROM 202, d'une mémoire externe (non représentée), d'un support de stockage, ou d'un réseau de communication. Lorsque la femto 110 est mise sous tension, le processeur 200 est capable de lire de la RAM 201 des instructions et de les exécuter. Ces instructions forment un programme d'ordinateur causant la mise en oeuvre, par le processeur 200, de tout ou partie des algorithmes et étapes décrits ci-après. Ainsi, tout ou partie des algorithmes et étapes décrits ci-après peut être implémenté sous forme logicielle par exécution d'un ensemble d'instructions par une machine programmable, tel qu'un DSP (« Digital Signal Processor » en anglais) ou un microcontrôleur. Tout ou partie des algorithmes et étapes décrits ci-après peut aussi être implémenté sous forme matérielle par une machine ou un composant dédié, tel qu'un FPGA (« Field-Programmable Gate Array » en anglais) ou un ASIC (« Application-Specific Integrated Circuit » en anglais).

La Fig. 3 illustre schématiquement un algorithme de recalage de la fréquence d'oscillation de l'oscillateur VCTCXO 113.

Dans une étape S301, la femto 110 obtient, en provenance du capteur de température 111, des mesures de la température ambiante de l'oscillateur VCTCXO 113 sur une plage temporelle prédéterminée.

Dans une étape S302 suivante, la femto 110 détermine une variation de la température ambiante sur la plage temporelle prédéterminée.

Dans une étape S303 suivante, la femto 110 ajuste la fréquence, ou le débit, d'accès à la référence temporelle ou fréquentielle externe pour recaler la fréquence d'oscillation de l'oscillateur VCTCXO 113.

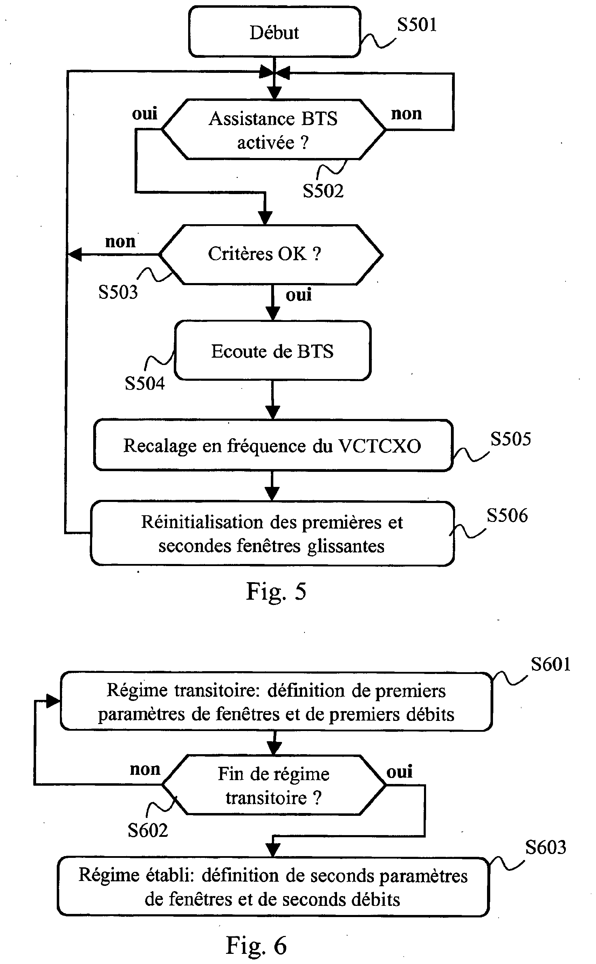

Comme déjà mentionné, la référence temporelle ou fréquentielle externe peut être implémentée par le serveur de temps 121 ou par la station de base BTS 130. Comme décrit ci-après en relation avec la Fig. 5, la station de base BTS 130 peut aussi être utilisée en assistance d'une synchronisation principale réalisée au moyen du serveur de temps 121.

Lorsque la référence temporelle externe est implémentée par le serveur de temps 121, la femto 110 augmente ou diminue la fréquence d'accès au serveur de temps 121 pour obtenir des informations temporelles. Cela permet à la femto 110 d'obtenir un plus grand nombre d'informations temporelles de la part du serveur de temps 121 pour une même plage temporelle lorsque les conditions de température ambiante varient significativement, c'est-à-dire que la femto 110 réduit le temps nécessaire pour intégrer les informations temporelles reçues du serveur de temps 121 pour corriger l'erreur en fréquence d'oscillation de l'oscillateur VCTCXO 113. Cela permet à la femto 110 de relâcher la contrainte sur le serveur de temps 121 lorsque les conditions de température ambiante se stabilisent ou sont stables.

Lorsque la référence fréquentielle externe est implémentée par la station de base BTS 130, la femto 110 augmente ou diminue la fréquence d'écoute de la station de base BTS 130 pour obtenir des informations fréquentielles. Le rafraîchissement de la fréquence d'oscillation de l'oscillateur VCTCXO 113 est donc plus fréquent lorsque les conditions de température ambiante varient significativement, et moins fréquent lorsque les conditions de température ambiante se stabilisent ou sont stables.

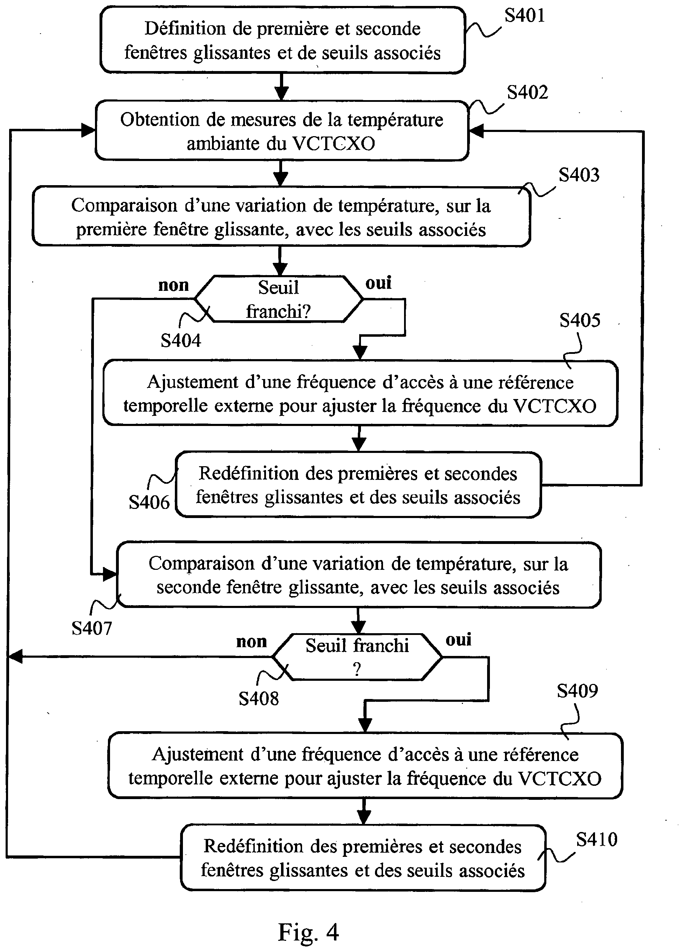

La Fig. 4 illustre schématiquement un algorithme de recalage de la fréquence d'oscillation de l'oscillateur VCTCXO 113, reposant sur une utilisation de fenêtres glissantes. L'algorithme de la Fig. 4 est adapté au recalage de la fréquence d'oscillation de l'oscillateur VCTCXO 113, par utilisation du serveur de temps 121.

Dans une étape S401, la femto 110 définit des première et seconde fenêtres glissantes, ainsi que des seuils respectifs associés de variation de température. Deux seuils sont ainsi définis par fenêtre glissante, excepté lorsque les débits minimum ou maximum sont atteints (où un seul seuil est utile). Un de ces seuils (seuil haut) permet à la femto 110 de décider d'augmenter la fréquence, ou le débit, d'accès à la référence temporelle externe (excepté quand le débit maximum est atteint), l'autre de ces seuils (seuil bas) permettant à la femto 110 de décider de diminuer la fréquence, ou le débit, d'accès à la référence temporelle externe (excepté quand le débit minimum est atteint). Les première et seconde fenêtres glissantes sont utilisées de manière complémentaire par la femto 110. La durée de la première fenêtre est plus longue que celle de la seconde fenêtre et le seuil haut de la première fenêtre glissante est strictement supérieur à celui de la seconde fenêtre glissante. La première fenêtre glissante vise à adapter la fréquence d'accès à la référence temporelle externe aux variations lentes de température ambiante, alors que la seconde fenêtre glissante vise à adapter la fréquence d'accès à la référence temporelle externe aux pics de variation de température ambiante. Une seule fenêtre glissante pourrait ainsi être définie pour adapter la fréquence d'accès à la référence temporelle externe aux variations de température ambiante.

Dans une étape S402 suivante, la femto 110 obtient des mesures de la température ambiante de l'oscillateur VCTCXO 113. A partir de ces mesures, la femto 110 détermine une variation de la température ambiante de l'oscillateur VCTCXO 113 sur chaque fenêtre glissante définie à l'étape S401.

Dans une étape S403 suivante, la femto 110 compare la variation de la température ambiante de l'oscillateur VCTCXO 113 sur la première fenêtre glissante avec chaque seuil (haut et bas) de variation de température associé à ladite première fenêtre glissante.

Dans une étape S404 suivante, la femto 110 vérifie si la variation de la température ambiante de l'oscillateur VCTCXO 113 sur la première fenêtre glissante dépasse l'un des seuils associés à ladite première fenêtre glissante. Lorsque la variation de la température ambiante de l'oscillateur VCTCXO 113 sur la première fenêtre glissante franchit un de ces seuils, une étape S405 est effectuée ; sinon, une étape S407 est effectuée.

Dans l'étape S405, la femto 110 ajuste la fréquence, ou le débit, d'accès à la référence temporelle externe, c'est-à-dire au serveur de temps 121, en fonction de la variation de la température ambiante de l'oscillateur VCTCXO 113 constatée sur la première fenêtre glissante. En d'autres termes, lorsque la variation de la température ambiante montre que la température ambiante de l'oscillateur VCTCXO 113 se stabilise sur la première fenêtre glissante, la femto 110 réduit les sollicitations auprès de la référence temporelle externe ; et, lorsque la variation de la température ambiante s'accélère sur la première fenêtre glissante, la femto 110 augmente les sollicitations auprès de la référence temporelle externe.

Dans une étape S406 suivante, la femto 110 redéfinit en conséquence les première et seconde fenêtres glissantes, ainsi que les seuils respectifs associés de variation de température. Pour ce faire, la femto 110 peut prédéfinir un ensemble de niveaux de variations de température. Chaque niveau i définit deux seuils hauts de variation de températures $STL_i$ et $STS_i$, correspondant respectivement aux première $FL_i$ et seconde $FS_i$ fenêtres glissantes de durées respectives $tL_i$ et $tS_i$. Chaque niveau i définit aussi deux seuils bas de variation de températures $STL_i'$ et $STS_i'$ correspondant respectivement aux première $FL_i$ et seconde $FS_i$ fenêtres glissantes. A chaque niveau de variation de température est associé un débit d'accès $d_i$ au serveur de temps 121 permettant d'assurer une précision minimale de fréquence prédéfinie. Les débits moyens d'accès $d_i$ au serveur de temps 121 dépendent de la stabilité de l'oscillateur VCTCXO 113, des seuils de température $STL_i$ et $STS_i$, ainsi que de la précision minimale souhaitée. Pour définir les seuils de température $STL_i$, $STL_i'$, $STS_i$ et $STS_i'$, ainsi que la précision associée, on peut utiliser la spécification constructeur de l'oscillateur VCTCXO 113, qui donne des variations de fréquence maximales pour une variation de température donnée. Aux niveaux de variation de température sont donc associés des seuils $STL_i$, $STL_i'$, $STS_i$ et $STS_i'$ différents, ainsi que des durées $tL_i$ et $tS_i$ différentes. Ainsi, lorsque la femto 110 effectue les étapes S405 et S406, la femto 110 se configure pour passer d'un niveau (*i*) à l'autre (*i+1* ou *i-1* selon la variation de la température ambiante de l'oscillateur VCTCXO 113). Le passage d'un niveau *i* de variation de température à un niveau *i+1* de variation plus importante s'accompagne d'une définition des fenêtres glissantes avec des durées $tS_{i+1}$ et $tL_{i+1}$ plus faibles, et d'une fréquence d'accès, ou d'un débit d'accès $d_{i+1}$, à la référence temporelle externe plus élevé. Le passage d'un niveau i de variation de température à un niveau *i-1* de variation plus faible s'accompagne d'une définition des fenêtres glissantes de durée $tS_{i-1}$ et $tL_{i-1}$ plus importantes, et d'une fréquence d'accès, ou d'un débit d'accès $d_{i-1}$, à la référence temporelle externe plus faible.

Les seuils bas associés aux fenêtres glissantes peuvent être définis relativement aux seuils hauts des fenêtres de niveau inférieur. Par exemple, les seuils bas $STL_i'$ et $STS_i'$ sont définis de la manière suivante :

$$STL_i' = STL_{i-1} - HL_{i-1} \text{ avec } HL_{i-1} = STL_{i-1} / 4$$

$$STS_i' = STS_{i-1} - HS_{i-1} \text{ avec } HS_{i-1} = STS_{i-1} / 3$$

où $HL_{i-1}$ et $HS_{i-1}$ représentent des valeurs d'hystérésis.

Prenons l'exemple décrit dans le tableau suivant qui est typique d'un régime établi, où quatre niveaux de variation de température ambiante de l'oscillateur VCTCXO 113 sont définis et où les seuils $STL_i'$ et $STS_i'$ sont respectivement définis relativement aux seuils $STL_{i-1}$ et $STS_{i-1}$ comme dans l'exemple ci-dessus :

**Tableau 1**

| Fenêtres et seuils | Précision | Débit d'accès |
|---|---|---|
| $FL_0$ : première fenêtre glissante de durée $tL_0$ = 6h<br>$STL_0$ : seuil à 6°C pour la fenêtre $FL_0$<br>$FS_0$ : seconde fenêtre glissante de durée $tS_0$ = 2 h<br>$STS_0$ : seuil à 4°C pour la fenêtre $FS_0$ | 125 ppb | $d_0$ |
| $FL_1$ : première fenêtre glissante de durée $tL_1$ = 4h<br>$STL_1$ : seuil à 9°C pour la fenêtre $FL_1$<br>$FS_1$ : seconde fenêtre glissante de durée $tS_1$ = 1,35 h<br>$STS_1$ : seuil à 6°C pour la fenêtre $FS_1$ | 125 ppb | $d_1$ = 2,2 $d_0$ |
| $FL_2$ : première fenêtre glissante de durée $tL_2$ = 2h<br>$STL_2$ : seuil à 12°C pour la fenêtre $FL_2$<br>$FS_2$ : seconde fenêtre glissante de durée $tS_2$ = 0,65 h<br>$STS_2$ : seuil à 8°C pour la fenêtre $FS_2$ | 150 ppb | $d_2$ = 5 $d_0$ |
| $FL_3$ : première fenêtre glissante de durée $tL_3$ = 1h<br>$STL_3$ : seuil à 24°C pour la fenêtre $FL_3$<br>$FS_3$ : seconde fenêtre glissante de durée $tS_3$ = 0,25 h<br>$STS_3$ : seuil à 10°C pour la fenêtre $FS_3$ | 250 ppb | $d_3$ = 20 $d_0$ |

Les seuils $STL_i$ et $STS_i$ peuvent être définis en fonction de conditions d'environnement climatique prévisibles de la femto 110. En effet, les possibilités de variation de la température ambiante de l'oscillateur VCTCXO 113 sont différentes lorsque la femto 110 est en environnement à température globalement régulé en température ou pas.

Le débit $d_0$ doit par exemple permettre de maintenir une précision de 125 ppb avec une variation maximale de température ambiante de l'oscillateur VCTCXO 113 de 6°C sur une fenêtre glissante de 6 heures et une variation maximale de 4°C sur une fenêtre glissante de 2 heures.

En prenant comme résolution du système de synchronisation par le serveur de temps 121 une valeur de 25 ppb, le débit $d_0$ peut être choisi pour qu'il permette de corriger un échelon de température de 4°C, la vitesse de variation de température étant maximale. Ceci en maintenant inférieure à 100 ppb l'erreur de fréquence provoquée par cet échelon de température et en annulant cette erreur de fréquence au bout d'un temps $2.tS_0$ = 4 heures. Ce principe peut s'appliquer de manière similaire aux autres débits $d_i$.

Dans un mode de réalisation particulier, lors d'un passage d'un niveau de variation à un autre, la femto 110 réinitialise le calcul de la variation de température en ajoutant dans les fenêtres de mesure $FL_{i+1}(j)$ et $FS_{i+1}(j)$ (ou $FL_{i-1}(j)$ et $FS_{i-1}(j)$ selon le sens du changement de niveau), où $j$ est un index temporel sur les fenêtres glissantes, une partie des variations de température des précédentes fenêtres de mesure $FL_i(j-1)$ et $FS_i(j-1)$, dont les variations correspondantes de fréquence d'oscillation de l'oscillateur VCTCXO 113 ne sont pas corrigées.

Le calcul des ajouts de variation de température à la réinitialisation s'appuie sur le fait qu'une variation de fréquence d'oscillation de l'oscillateur VCTCXO 113 est corrigée au bout d'une durée maximale égale à $2.tS_i$ avec un débit $d_i$. Ainsi, en considérant un changement de niveau partant d'un niveau $i$ à un niveau $i+1$ :

- les variations de températures antérieures à l'instant $t_0 - 2.tS_i$ sont ignorées, où $t_0$ représente l'instant du passage d'un niveau à un autre ;
- Les variations de la fréquence d'oscillation de l'oscillateur VCTCXO 113 entre les instants $to - 2.tS_i$ et $t_0 - (3.tSi/2)$ sont corrigées aux trois quarts à l'instant to. L'ajout de variation de température à prendre en compte lors de la réinitialisation est alors égale à $1/4.\Delta TS_{i,3}$, où $\Delta TS_{i,3}$ représente la variation de température ambiante dans la fenêtre temporelle allant de $t_0 - 2.tS_i$ à $t_0 - (3.tS_i/2)$ ;
- Les variations de fréquence d'oscillation de l'oscillateur VCTCXO 113 entre les instants $to - (3.tSi/2)$ et $to - tS_i$ sont corrigées de moitié à l'instant $t_0$. L'ajout de variation de température à prendre en compte lors de la réinitialisation est alors égale à $1/2.\Delta TS_{i,2}$, où $\Delta TS_{i,2}$ est la variation de température ambiante dans la fenêtre temporelle allant de $t_0 - (3.tS_i/2)$ à $t_0 - tS_i$ ; et
- Les variations de fréquence d'oscillation de l'oscillateur VCTCXO 113 entre les instants $t_0 - tS_i$ et $t_0 - tS_i/2$ sont corrigées d'un quart à l'instant $t_0$. L'ajout de variation de température à prendre en compte lors de la réinitialisation est alors égale à $3/4.\Delta TS_{i,1}$, où $\Delta TS_{i,1}$ représente la variation de température ambiante dans la fenêtre temporelle allant de $t_0 - tS_i$ à $t_0 - tS_i/2$.

**EP 2 997 661 B1**

Les variations de températures après le changement de niveau sont alors:

- Dans la fenêtre $FL_{i+1}$, pour l'intervalle allant de $t_0$ à $t_0 + (2.tS_i - tL_{i+1})$, la variation corrigée de température ambiante est égale à la variation de température mesurée sur la fenêtre $FL_{i+1}$ à laquelle est ajoutée $1/4.\Delta TL_{i,i+1}$, où $\Delta TL_{i,i+1}$ représente la variation de température ambiante dans la fenêtre temporelle allant de $t_0 - tL_{i+1}$ à to - $2.tS_i$ ; et
- Dans la fenêtre $FS_{i+1}$, la variation corrigée de température ambiante est égale à la variation de température mesurée sur la fenêtre $FS_{i+1}$ à laquelle est ajouté $1/4.\Delta TS_{i,3} + 1/2.\Delta TS_{i,2} + 3/4.\Delta TS_{i,1}$ pour l'intervalle allant de to à $t_0 + tS_{i+1}$, et à laquelle est ajoutée $3/8.\Delta TS_{i,1}$ pour l'intervalle temporel allant de $t_0 + tS_{i+1}$ à $t_0 + 2.tS_i$.

Ainsi, la femto 110 reporte sur chaque fenêtre glissante du niveau *i+1* une partie des variations de température ambiante détectées pendant la ou les fenêtres glissantes du niveau i.

Dans un mode de réalisation particulier, lorsque la femto 110 détermine si les variations de température ambiante franchissent le seuil bas $STS_i'$, la femto 110 ajoute aux variations de température mesurées dans la fenêtre glissante $FS_i$ les variations de température mesurées dans la partie de fenêtre glissante $FS_{i-1}$ allant de $t_0' - tS_i$ à $t_0' - tS_{i-1}$ en leur appliquant une pondération, par exemple un facteur de 0.5, où $t_0'$ représente l'instant de fin de la fenêtre glissante considérée. De même, lorsque la femto détermine si les variations de température ambiante franchissent le seuil bas $STL_i'$, la femto 110 ajoute aux variations de température mesurées dans la fenêtre glissante $FL_i$ les variations de température mesurées dans la partie de fenêtre glissante $FL_{i-1}$ allant de $t_0' - tL_i$ à $t_0' - tL_{i-1}$ en leur appliquant une pondération, par exemple un facteur de 0.35.

Lorsque l'étape S406 est effectuée, l'étape S402 est répétée avec les paramètres de fenêtres glissantes nouvellement applicables.

Dans l'étape S407, la femto 110 effectue, pour la seconde fenêtre glissante, la même opération que dans l'étape S403 pour la première fenêtre glissante. La femto 110 compare alors la variation de la température ambiante de l'oscillateur VCTCXO 113 sur la seconde fenêtre glissante avec chaque seuil (haut et bas) de variation de température associé à ladite seconde fenêtre glissante.

Dans une étape S408 suivante, la femto 110 vérifie si la variation de la température ambiante de l'oscillateur VCTCXO 113 sur la seconde fenêtre glissante dépasse l'un des seuils associés à ladite seconde fenêtre glissante. Lorsque la variation de la température ambiante de l'oscillateur VCTCXO 113 sur la seconde fenêtre glissante franchit un de ces seuils, une étape S409 est effectuée ; sinon, l'étape S402 est répétée en conservant les paramètres de fenêtres glissantes.

Dans l'étape S409, la femto 110 ajuste la fréquence, ou le débit, d'accès à la référence temporelle externe, c'est-à-dire au serveur de temps 121, en fonction de la variation de la température ambiante de l'oscillateur VCTCXO 113 constatée sur la seconde fenêtre glissante. En d'autres termes, lorsque la variation de la température ambiante montre que la température ambiante de l'oscillateur VCTCXO 113 se stabilise sur la seconde fenêtre glissante, la femto 110 réduit les sollicitations auprès de la référence temporelle externe ; et, lorsque la variation de la température ambiante s'accélère sur la seconde fenêtre glissante, la femto 110 augmente les sollicitations auprès de la référence temporelle externe.

Il convient de noter que l'algorithme de la Fig. 4 peut être modifié pour effectuer les comparaisons des étapes S403 et S407 en une même étape.

La Fig. 5 illustre schématiquement un algorithme complémentaire de recalage de la fréquence d'oscillation de l'oscillateur VCTCXO 113, reposant sur une synchronisation avec une station de base BTS, comme par exemple la station de base BTS 130. La référence temporelle ou fréquentielle externe est alors principalement implémentée par le serveur de temps 121, la station de base BTS 130 assurant une assistance pour recaler la fréquence d'oscillation de l'oscillateur VCTCXO 113 de manière à soulager les accès au serveur de temps 121 en tant que référence temporelle externe.

L'algorithme démarre dans une étape S501. Dans une étape S502 suivante, la femto 110 vérifie si l'assistance par station de base BTS est activée.

En considérant que la seconde interface de communication 114 de la femto 110 ne comporte qu'une chaîne d'émission / réception, l'assistance par station de base BTS n'est activée que pendant des intervalles de temps sans communication entre la femto 110 et les équipements mobiles UEs 131, 132. En effet, comme on le verra par la suite, l'assistance par la station de base BTS 130 implique que la femto 110 se mette à l'écoute de cellules voisines, ce qui nécessite un blocage de toute transmission radio et ce qui, selon la durée et la fréquence d'un tel blocage, peut provoquer des départs des équipements mobiles UEs 131, 132, ainsi que des échecs de prise ou de réception de communication. Préférentiellement, la durée de l'écoute des cellules voisines effectuée pour une synchronisation est limitée typiquement à l'ordre de la seconde, en s'appuyant sur une écoute complète préalable des cellules voisines effectuée régulièrement (typiquement une fois par jour, ainsi qu'à la mise sous tension de la femto 110). Cette écoute complète permet d'établir une liste des stations de base BTS avec leur niveau de puissance, leur fréquence et leur précision. L'écoute complète peut cependant durer quelques minutes puisque toutes les fréquences sont écoutées et un certain nombre de paramètres

8

en provenance des stations de base BTS sont décodés et/ou analysés (comme leurs identifiants respectifs, le contenu du canal CPICH (« Common PIlot CHannel » en anglais),...). L'écoute complète étant contraignante au niveau de sa durée, elle est préférentiellement effectuée uniquement à des moments où cette écoute complète gêne le moins possible (dans la nuit avec absence de communication par exemple).

Les stations de base BTS utilisées pour la synchronisation sont les stations de base BTS 2G et 3G. De telles stations de base BTS peuvent être réparties en trois classes de précision : 50 ppb, 100 ppb et 250 ppb. Il s'agit alors de privilégier les stations de base BTS de précision 50 ppb et d'écarter celles de précision 250 ppb. Il convient de noter que les stations de base BTS 2G et 3G peuvent être distinguées entre elles grâce à leur fréquence d'émission.

Les stations de base BTS 2G ont deux classes de précision : 100 ppb pour les Pico et Micro station de base BTS, et 50 ppb pour les autres stations de base BTS 2G. Cependant les classes de précisions peuvent être difficilement identifiables lors d'une écoute des cellules. Toutes les BTS 2G peuvent alors préférentiellement être classées comme des BTS de précision 100 ppb.

Les stations de base BTS 3G ont trois classes de précision : 250 ppb pour les stations de base domestiques HBS (« Home Base Stations » en anglais) dont la femto 110 fait partie, 100 ppb pour les stations de base BTS dites « local area » et pour les stations de base BTS dites « medium range », et 50 ppb pour les stations de base BTS dites « wide area ». Les stations de base BTS 3G transmettent l'information de la puissance maximum du canal CPICH dont les niveaux sont différents pour les trois classes de précision de stations de base BTS 3G. Cette information peut être décodée lors d'une écoute des cellules. Les stations de base domestiques HBS doivent être écartées. Ainsi, si la valeur de puissance maximum du canal CPICH est inférieure ou égale à 10 dBm, il est possible que la station de base BTS soit une femto. Cette station de base BTS doit alors être écartée pour l'assistance à la synchronisation. De même, si la valeur de puissance maximum du canal CPICH est supérieure à 28 dBm, la station de base BTS peut être considérée comme une station de base BTS dite « wide area » avec une précision inférieure à 50 ppb et doit donc être privilégiée. Dans tous les autres cas, la précision à prendre en compte est 100 ppb. A noter que les stations de base ainsi classées avec une précision de 100 ppb peuvent être des stations de base BTS 2G de précision 50 ppb, ou peuvent aussi être des stations de base BTS 3G de précision 50 ppb dites « wide area ». En effet, les puissances maximum du canal CPICH des différentes classes de station de base BTS 3G sont uniquement spécifiées par leur limite supérieure (<10dBm pour les stations de base BTS de précision 250 ppb, < 28dBm pour les stations de base BTS de précision 100 ppb et pas de limite supérieure pour les stations de base BTS de précision 50 ppb)).

Un autre critère d'activation de l'assistance par station de base BTS est alors la détection d'au moins une station de base BTS 2G ou 3G avec une précision de 50 ppb ou 100 ppb lors de l'écoute complète des cellules voisines.

D'autres critères peuvent être utilisés pour activer ou non l'assistance par station de base BTS, comme par exemple : un intervalle de temps minimum entre deux activations de l'assistance par station de base BTS, pas d'équipement mobile UE connecté à la femto 110, activation possible pendant un intervalle de temps prédéfini tel que pendant la nuit, etc. De plus, considérant les niveaux de variation de température ambiante définis en relation avec la Fig. 4, tant que la variation de la température ambiante de l'oscillateur VCTCXO 113 est contenue dans le niveau de variation de température ambiante le plus faible, le débit d'accès au serveur de temps 121 est le plus faible (do) et l'assistance par station de base BTS n'est pas utile et est alors désactivée.

Si l'assistance par station de base BTS est activée, une étape S503 est effectuée ; sinon, l'étape S502 est répétée.

Dans l'étape S503, la femto 110 vérifie si un ou plusieurs critères de synchronisation grâce à l'assistance d'une station de base BTS sont remplis. Ces critères sont préférentiellement parmi les suivants :

a) la précision d'au moins une station de base BTS détectée lors de l'écoute complète des cellules voisines est meilleure que la précision correspondant au niveau $i$ de variation de température ambiante dans lequel la femto 110 se trouve, et la différence entre la variation de température ambiante et un des seuils hauts défini pour ledit niveau $i$ est inférieure à une marge prédéfinie ;
b) la précision d'au moins une station de base BTS détectée lors de l'écoute complète des cellules voisines est meilleure que la précision correspondant au niveau $i-1$ de variation de température ambiante (donc aussi que la précision correspondant au niveau $i$), la femto 110 se trouvant au niveau $i$ de variation de température ambiante, et la variation de température est en-dessous des seuils hauts de variation de température correspondant aux fenêtres glissantes du niveau $i-1$ ;
c) la précision d'au moins une station de base BTS détectée lors de l'écoute complète des cellules voisines est significativement meilleure que la précision correspondant au niveau $i$ de variation de température ambiante dans lequel la femto 110 se trouve.

Le cas a) permet de maintenir le débit d'accès au serveur de temps en cours. La marge permet que les critères d'activation de l'assistance par station de base BTS aient plus de chance d'être réunis avant que le seuil considéré ne soit atteint. Le cas b) permet de passer à un débit d'accès (à la référence temporelle externe implémentée par le serveur de temps 121) inférieur, en diminuant un temps d'attente lié à l'hystérésis. Le cas c) permet de passer à un débit d'accès (à la référence temporelle externe implémentée par le serveur de temps 121) inférieur.

Lorsque le(s) critère(s) est (sont) rempli(s), une étape S504 est effectuée ; sinon, l'étape S502 est répétée.

Dans l'étape S504, la femto 110 se met à l'écoute des stations de base BTS de la liste établie lors de l'écoute complète, correspondant aux critères de l'étape S503 et permettant de complémenter la synchronisation réalisée grâce au serveur de temps 121.

L'écoute de synchronisation ne concerne ainsi préférentiellement que les stations de base répondant aux critères de synchronisation de l'étape S503 et lors de cette écoute, c'est principalement l'écart de fréquence avec la (les) station(s) de base qui est mesuré grâce à la chaîne réception de la femto 110. Cette écoute de synchronisation simplifiée permet de réduire la durée d'écoute typiquement à l'ordre de la seconde. Pour diminuer la probabilité de mesurer une fréquence avec une erreur extrême (proche de 100 ppb) en cas de synchronisation avec une station de base BTS classée avec une précision 100 ppb, la femto 110 peut effectuer une moyenne pondérée sur les erreurs de fréquence mesurées, lorsque plusieurs stations de base BTS de précision 100 ppb sont détectées. La pondération est croissante avec la valeur de puissance du canal CPICH des stations de base BTS 3G lorsque cette valeur de puissance du canal CPICH est supérieure à 30 dBm, la probabilité d'être en présence d'une station de base BTS dite « wide area » et donc de précision 50 ppb, étant croissante avec la valeur de puissance du canal CPICH.

Dans l'étape S505, la femto 110 effectue le recalage de la fréquence d'oscillation de l'oscillateur VCTCXO 113 grâce à l'écart de fréquence moyen mesuré avec la(les) station(s) de base BTS lors de l'étape S504.

Dans une étape S506 suivante, la femto 110 réinitialise les première et seconde fenêtres glissantes.

Dans un mode de réalisation particulier, une variation de température initiale prenant en compte l'erreur de fréquence maximale de la station de base BTS ayant servi à la mise à jour de la fréquence d'oscillation de l'oscillateur VCTCXO 113 est ajoutée aux variations de température ambiante mesurées. Pour ce faire, la femto 110 traduit la précision de la station de base BTS ayant servi à la mise à jour de la fréquence d'oscillation de l'oscillateur VCTCXO 113 en une variation de température ambiante correspondante, et la femto 110 ajoute cette variation de température aux variations de température ambiante mesurées sur les premières (en séquence) fenêtres glissantes FLi et FSi après la synchronisation assistée par ladite station de base BTS.

Une fois l'étape S506 effectuée, l'étape S502 est répétée.

La Fig. 6 illustre schématiquement un algorithme de définition des fenêtres glissantes, selon si la femto 110 est en régime transitoire ou en régime établi. Le régime transitoire correspond à la chauffe des composants électroniques de la femto 110, par exemple suite à la mise sous tension de la femto 110.

En régime transitoire, les variations de la température ambiante de l'oscillateur VCTCXO 113 sont provoquées :

- par la chauffe des composants de la femto 110, ce qui peut engendrer des variations de température ambiante de l'oscillateur VCTCXO 113 importantes, par exemple de 25°C sur une durée de 15 minutes ; et/ou
- par la variation de la température ambiante externe à la femto 110, ce qui peut engendrer par exemple un maximum de 20°C de variation de température ambiante de l'oscillateur VCTCXO 113 sur une durée d'une heure ; et/ou
- par la prise ou la libération d'une communication ou le changement de puissance radio, ce qui engendre en général des variations de température ambiante de l'oscillateur VCTCXO 113 de faible amplitude (typiquement quelques degrés Celsius sur 10 ou 20 minutes).

En régime établi, les variations de la température ambiante de l'oscillateur VCTCXO 113 correspondent à celles indiquées ci-dessus en régime transitoire sans les variations provoquées par la chauffe des composants.

Puisque les variations de fréquence d'oscillation de l'oscillateur VCTCXO 113 correspondantes sont beaucoup plus faibles en régime établi (comparativement au régime transitoire), les débits d'accès moyens au serveur de temps 121 sont également beaucoup plus faibles en régime établi (comparativement au régime transitoire).

Dans une étape S601, la femto 110 est en régime transitoire, par exemple juste après la mise sous tension de la femto 110. La femto 110 utilise alors des premières fréquences, ou premiers débits, d'accès à la référence temporelle ou fréquentielle externe.

Dans une étape S602, la femto 110 vérifie si la fin du régime transitoire est atteinte. Selon un premier exemple, la fin du régime transitoire est considérée comme atteinte lorsqu'une période de durée prédéfinie est écoulée depuis l'enclenchement du régime transitoire, e.g. la mise sous tension de la femto 110. Selon un second exemple, la fin du régime transitoire est considérée comme atteinte lorsque la température ambiante de l'oscillateur VCTCXO 113 est substantiellement stable.

Lorsque la fin du régime transitoire est atteinte, une étape S603 est effectuée ; sinon, les paramètres du régime transitoire sont maintenus et l'étape S601 est répétée.

Dans l'étape S603, la femto 110 est en régime établi, la montée en température des composants étant considérée comme terminée. La femto 110 utilise alors des secondes fréquences, ou seconds débits, d'accès à la référence temporelle ou fréquentielle externe.

Les fréquences d'accès à la référence temporelle ou fréquentielle externe sont plus grandes en régime transitoire. De plus, lorsque les niveaux de variation de température ambiante présentés à la Fig. 4 sont mis en oeuvre, les seuils et les durées des fenêtres glissantes diffèrent entre le régime transitoire et le régime établi, afin d'être adaptés à des variations plus rapides et de plus fortes amplitudes en régime transitoire comparé au régime établi. Ainsi, pour le niveau $i_m$ de variation de température le plus élevé, le débit d'accès $d_{imt}$ au serveur de temps 121 est par exemple trois fois plus élevé en régime transitoire qu'en régime établi, et la durée des fenêtres glissantes est trois fois plus faible en régime transitoire qu'en régime établi (le seuil de température haut pouvant rester identique). En régime transitoire un niveau $i_{mt}$-1 intermédiaire de variation de température peut être défini avec un débit d'accès $d_{imt-1}$ moins élevé, correspondant à des variations de température ambiante externe à la femto 110 faibles. Enfin, en régime transitoire, un niveau de température avec un débit d'accès $d_{imt-2}$ nettement plus faible peut être défini en cas d'assistance de la synchronisation par station de base BTS. Pour pouvoir corriger les variations de fréquence en régime transitoire en utilisant le débit d'accès $d_{imt-2}$, l'assistance de la synchronisation par station de base BTS est nécessaire et la fréquence d'écoute des stations de base BTS doit être plus élevée qu'en régime établi pour maintenir le plus longtemps possible le débit d'accès $d_{imt-2}$, comme par exemple une écoute toutes les 3 ou 4 minutes. Il convient alors d'élargir les critères d'activation de l'assistance de la synchronisation par station de base BTS, par exemple en diminuant l'intervalle de temps entre deux écoutes de stations de base BTS.

A noter que l'exemple du tableau 1 donne des paramètres de fenêtres glissantes et des débits d'accès au serveur de temps 121 qui sont typiques à un régime établi.

L'algorithme de la Fig. 6 permet de réduire le temps de mise en service de la femto 110, suite à un reboot ou à une mise sous tension de la femto 110, en permettant de corriger les variations de fréquence de l'oscillateur VCTCXO 113 en régime transitoire tout en optimisant le débit d'accès moyen au serveur de temps 121.

## Revendications

1. Procédé de recalage d'une fréquence d'oscillation d'un oscillateur contrôlé en tension et compensé en température (113) d'un dispositif (110), ledit dispositif accédant à une référence temporelle ou fréquentielle externe (121 ; 130) pour recaler la fréquence d'oscillation dudit oscillateur en fonction d'informations temporelles ou respectivement fréquentielles fournies par ladite référence temporelles ou fréquentielle externe, ledit dispositif comportant un capteur de température (111) et effectue les étapes suivantes :

   - déterminer (S302) une variation de température ambiante dudit oscillateur sur une plage temporelle prédéterminée grâce à des mesures dudit capteur ; et
   - ajuster (S303) une fréquence, ou un débit, d'accès à la référence temporelle ou fréquentielle externe pour obtenir lesdites informations temporelles ou respectivement fréquentielles pour recaler la fréquence d'oscillation dudit oscillateur, en fonction de la variation de température déterminée.

2. Procédé selon la revendication 1, **caractérisé en ce que**, une isolation thermique étant réalisée grâce à un premier capot (150) recouvrant ledit oscillateur sur un circuit imprimé (160) dans lequel sont aménagés des trous (170) autour dudit oscillateur et grâce à un deuxième capot (151) recouvrant la face opposée du circuit imprimé, ledit dispositif détermine la variation de température ambiante dudit oscillateur grâce en outre à une fonction de transfert de ladite isolation thermique.

3. Procédé selon l'une quelconque des revendications 1 et 2, **caractérisé en ce que** la référence temporelle externe est implémentée par un serveur de temps (121).

4. Procédé selon la revendication 3, **caractérisé en ce que**, plusieurs niveaux de variation de température ambiante dudit oscillateur étant définis, chaque niveau étant associé à au moins une fenêtre glissante respective, chaque fenêtre glissante étant associée à au moins un seuil de variation de température ambiante permettant de passer d'un niveau à un autre, chaque niveau étant en outre associé à une fréquence ou un débit d'accès à la référence temporelle externe, le dispositif effectue les étapes suivantes :

   - déterminer (S404, S408) si la variation de température ambiante sur chaque fenêtre glissante d'un premier niveau de variation de température ambiante franchit un seuil associé à ladite fenêtre glissante ;
   - changer (S406, S410) pour un second niveau lorsque ledit seuil est franchi, et appliquer la fréquence ou le débit d'accès à la référence temporelle externe qui est associé(e) audit second niveau.

5. Procédé selon la revendication 4, **caractérisé en ce que** deux fenêtres glissantes sont définies par niveau de variation de température ambiante.

**6.** Procédé selon l'une quelconque des revendications 4 à 5, **caractérisé en ce que** des niveaux distincts de variation de température ambiante dudit oscillateur sont définis pour un régime transitoire et un régime établi dudit dispositif.

**7.** Procédé selon l'une quelconque des revendications 4 à 6, **caractérisé en ce que**, lors d'un passage du premier niveau au second niveau, le dispositif reporte sur chaque fenêtre glissante dudit second niveau une partie des variations de température ambiante détectées pendant chaque fenêtre glissante du premier niveau.

**8.** Procédé selon l'une quelconque des revendications 4 à 7, **caractérisé en ce que**, chaque niveau de variation de température ambiante étant associé à une précision de fréquence d'oscillation dudit oscillateur, le dispositif étant une femto, le dispositif effectue les étapes suivantes :

- détecter une station de base (130) gérant une cellule voisine à la femtocell gérée par la femto de meilleure précision que celle du niveau de variation de température ambiante dans lequel le dispositif se trouve ;
- attendre une absence de communications dans la femtocell, puis se mettre en écoute (S504) de la station de base pour obtenir les informations fréquentielles pour recaler la fréquence d'oscillation dudit oscillateur.

**9.** Procédé selon la revendication 8, **caractérisé en ce que** le dispositif sélectionne ladite station de base pour recaler la fréquence d'oscillation dudit oscillateur dans chacun des cas suivants :

- la différence entre la variation de température ambiante déterminée et chaque seuil de variation de température ambiante associé à une fenêtre glissante du niveau de variation de température ambiante dans lequel le dispositif se trouve est inférieure à une marge prédéfinie ;
- la précision de la station de base est meilleure que la précision correspondant au niveau inférieur de variation de température ambiante par rapport au niveau de variation de température ambiante dans lequel le dispositif se trouve, et la variation de température ambiante déterminée est en-dessous d'un seuil haut de variation de température associé à la ou aux fenêtre(s) glissante(s) dudit niveau inférieur.

**10.** Procédé selon l'une quelconque des revendications 8 et 9, **caractérisé en ce que** le dispositif effectue les étapes suivantes :

- traduire la précision de la station de base en une variation de température ambiante correspondante ; et
- réinitialiser (S506) chaque fenêtre glissante et ajouter à chaque fenêtre glissante ladite variation de température ambiante correspondante.

**11.** Procédé selon l'une quelconque des revendications 1 et 2, **caractérisé en ce que**, ledit dispositif étant une femto, la référence fréquentielle externe est implémentée par une station de base (130) gérant une cellule voisine à la femtocell gérée par la femto.

**12.** Dispositif (110) comportant un oscillateur contrôlé en tension et compensé en température (113), le dispositif étant adapté pour accéder à une référence temporelle ou fréquentielle externe et pour recaler la fréquence d'oscillation dudit oscillateur en fonction d'informations temporelles ou respectivement fréquentielles fournies par ladite référence temporelle ou fréquentielle externe, comportant en plus:

- un capteur (111) de température ambiante de l'oscillateur ;
- des moyens pour déterminer (S302) une variation de température ambiante dudit oscillateur sur une plage temporelle prédéterminée grâce à des mesures dudit capteur ; et
- des moyens pour ajuster (S303) une fréquence, ou un débit, d'accès à la référence temporelle ou fréquentielle externe pour obtenir lesdites informations temporelles ou respectivement fréquentielles pour recaler la fréquence d'oscillation dudit oscillateur, en fonction de la variation de température déterminée.

**13.** Dispositif selon la revendication 12, **caractérisé en ce qu'**il comporte un circuit imprimé (160) dans lequel des trous (170) sont aménagés autour dudit oscillateur, un premier capot (150) recouvrant ledit oscillateur sur le circuit imprimé et un deuxième capot (151) recouvrant la face opposée du circuit imprimé afin de réaliser une isolation thermique, ledit dispositif comporte des moyens pour déterminer la variation de température ambiante dudit oscillateur grâce en outre à une fonction de transfert de ladite isolation thermique.

**EP 2 997 661 B1**

**Patentansprüche**

1. Verfahren zur Neueinstellung einer Oszillationsfrequenz eines spannungsgesteuerten und temperaturkompensierten Oszillators (113) einer Vorrichtung (110), wobei die Vorrichtung auf eine externe Zeit- oder Frequenzreferenz (121; 130) zugreift, um die Oszillationsfrequenz des Oszillators in Abhängigkeit von Zeit- bzw. Frequenzinformationen, die von der externen Zeit- oder Frequenzreferenz geliefert werden, neu einzustellen, wobei die Vorrichtung einen Temperatursensor (111) aufweist und die folgenden Schritte ausführt:

   - Bestimmen (S302) einer Änderung der Umgebungstemperatur des Oszillators in einem vorbestimmten Zeitbereich mithilfe von Messungen des Sensors; und
   - Einstellen (S303) einer Frequenz, oder einer Rate, des Zugriffs auf die externe Zeit- oder Frequenzreferenz, um die Zeit- bzw. Frequenzinformationen zur Neueinstellung der Oszillationsfrequenz des Oszillators zu erhalten, in Abhängigkeit von der bestimmten Temperaturänderung.

2. Verfahren nach Anspruch 1, **dadurch gekennzeichnet, dass**, wenn eine Wärmeisolation mithilfe einer ersten Abdeckhaube (150), die den Oszillator auf einer gedruckten Schaltung (160) abdeckt, in welcher Löcher (170) um den Oszillator herum angeordnet sind, und mithilfe einer zweiten Abdeckhaube (151), welche die gegenüberliegende Seite der gedruckten Schaltung abdeckt, realisiert ist, die Vorrichtung die Änderung der Umgebungstemperatur des Oszillators außerdem mithilfe einer Übertragungsfunktion der Wärmeisolation bestimmt.

3. Verfahren nach einem der Ansprüche 1 und 2, **dadurch gekennzeichnet, dass** die externe Zeitreferenz durch einen Zeitserver (121) implementiert ist.

4. Verfahren nach Anspruch 3, **dadurch gekennzeichnet, dass**, wenn mehrere Änderungsniveaus der Umgebungstemperatur des Oszillators definiert sind, wobei jedes Niveau wenigstens einem jeweiligen gleitenden Fenster zugeordnet ist, wobei jedes gleitende Fenster wenigstens einem Schwellenwert der Änderung der Umgebungstemperatur zugeordnet ist, der es ermöglicht, von einem Niveau zu einem anderen überzugehen, wobei jedes Niveau außerdem einer Frequenz oder einer Rate des Zugriffs auf die externe Zeitreferenz zugeordnet ist, die Vorrichtung die folgenden Schritte ausführt:

   - Bestimmen (S404, S408), ob die Änderung der Umgebungstemperatur in jedem gleitenden Fenster eines ersten Änderungsniveaus der Umgebungstemperatur einen Schwellenwert überschreitet, der dem gleitenden Fenster zugeordnet ist;
   - Wechseln (S406, S410) zu einem zweiten Niveau, wenn der Schwellenwert überschritten ist, und Anwenden der Frequenz oder der Rate des Zugriffs auf die externe Zeitreferenz, welche dem zweiten Niveau zugeordnet ist.

5. Verfahren nach Anspruch 4, **dadurch gekennzeichnet, dass** zwei gleitende Fenster pro Änderungsniveau der Umgebungstemperatur definiert werden.

6. Verfahren nach einem der Ansprüche 4 bis 5, **dadurch gekennzeichnet, dass** unterschiedliche Änderungsniveaus der Umgebungstemperatur des Oszillators für einen Übergangsbetrieb und einen stationären Betrieb der Vorrichtung definiert sind.

7. Verfahren nach einem der Ansprüche 4 bis 6, **dadurch gekennzeichnet, dass** bei einem Übergang von ersten Niveau zum zweiten Niveau die Vorrichtung auf jedes gleitende Fenster des zweiten Niveaus einen Teil der Änderungen der Umgebungstemperatur überträgt, die während jedes gleitenden Fensters des ersten Niveaus detektiert wurden.

8. Verfahren nach einem der Ansprüche 4 bis 7, **dadurch gekennzeichnet, dass**, wenn jedes Änderungsniveau der Umgebungstemperatur einer Genauigkeit der Oszillationsfrequenz des Oszillators zugeordnet ist, wobei die Vorrichtung eine Femto-Basisstation ist, die Vorrichtung die folgenden Schritte ausführt:

   - Detektieren einer Basisstation (130), die eine der von der Femto-Basisstation verwalteten Femtozelle benachbarte Zelle verwaltet, mit einer Genauigkeit, die höher als diejenige des Änderungsniveaus der Umgebungstemperatur ist, in dem sich die Vorrichtung befindet;
   - Warten auf ein Nichtvorhandensein von Kommunikationen in der Femtozelle, anschließend Abhören (S504) der Basisstation, um die Frequenzinformationen zur Neueinstellung der Oszillationsfrequenz des Oszillators zu gewinnen.

9. Verfahren nach Anspruch 8, **dadurch gekennzeichnet, dass** die Vorrichtung die Basisstation zur Neueinstellung der Oszillationsfrequenz des Oszillators in jedem der folgenden Fälle wählt:

- die Differenz zwischen der bestimmten Änderung der Umgebungstemperatur und jedem Schwellenwert der Änderung der Umgebungstemperatur, der einem gleitenden Fenster des Änderungsniveaus der Umgebungstemperatur, in dem sich die Vorrichtung befindet, zugeordnet ist, ist kleiner als eine vordefinierte Marge;
- die Genauigkeit der Basisstation ist höher als die Genauigkeit, die dem niedrigeren Änderungsniveau der Umgebungstemperatur entspricht, bezogen auf das Änderungsniveau der Umgebungstemperatur, in dem sich die Vorrichtung befindet, und die bestimmte Änderung der Umgebungstemperatur liegt unter einem oberen Schwellenwert der Temperaturänderung, der dem (den) gleitenden Fenster(n) des niedrigeren Niveaus zugeordnet ist.

10. Verfahren nach einem der Ansprüche 8 und 9, **dadurch gekennzeichnet, dass** die Vorrichtung die folgenden Schritte ausführt:

- Übersetzen der Genauigkeit der Basisstation in eine entsprechende Änderung der Umgebungstemperatur; und
- Neuinitialisieren (S506) jedes gleitenden Fensters und Hinzufügen der entsprechenden Änderung der Umgebungstemperatur zu jedem gleitenden Fenster.

11. Verfahren nach einem der Ansprüche 1 und 2, **dadurch gekennzeichnet, dass**, wenn die Vorrichtung eine Femto-Basisstation ist, die externe Frequenzreferenz durch eine Basisstation (130) implementiert wird, die eine der von der Femto-Basisstation verwalteten Femtozelle benachbarte Zelle verwaltet.

12. Vorrichtung (110), die einen spannungsgesteuerten und temperaturkompensierten Oszillator (113) umfasst, wobei die Vorrichtung dafür ausgelegt ist, auf eine externe Zeit- oder Frequenzreferenz zuzugreifen und die Oszillationsfrequenz des Oszillators in Abhängigkeit von Zeit- bzw. Frequenzinformationen, die von der externen Zeit- oder Frequenzreferenz geliefert werden, neu einzustellen, außerdem umfassend:

- einen Sensor (111) für die Umgebungstemperatur des Oszillators;
- Mittel zum Bestimmen (S302) einer Änderung der Umgebungstemperatur des Oszillators in einem vorbestimmten Zeitbereich mithilfe von Messungen des Sensors; und
- Mittel zum Einstellen (S303) einer Frequenz, oder einer Rate, des Zugriffs auf die externe Zeit- oder Frequenzreferenz, um die Zeit- bzw. Frequenzinformationen zur Neueinstellung der Oszillationsfrequenz des Oszillators zu erhalten, in Abhängigkeit von der bestimmten Temperaturänderung.

13. Vorrichtung nach Anspruch 12, **dadurch gekennzeichnet, dass** sie eine gedruckte Schaltung (160), in welcher Löcher (170) um den Oszillator herum angeordnet sind, eine erste Abdeckhaube (150), die den Oszillator auf der gedruckten Schaltung abdeckt, und eine zweite Abdeckhaube (151), welche die gegenüberliegende Seite der gedruckten Schaltung abdeckt, um eine Wärmeisolation zu realisieren, umfasst, wobei die Vorrichtung Mittel zum Bestimmen der Änderung der Umgebungstemperatur des Oszillators außerdem mithilfe einer Übertragungsfunktion der Wärmeisolation umfasst.

**Claims**

1. Method for adjusting an oscillation frequency of a voltage-controlled and temperature-compensated oscillator (113) of a device (110), said device accessing an external time or frequency reference (121; 130) to adjust the oscillation frequency of said oscillator according to time or respectively frequency information supplied by said external time reference, said device comprising a temperature sensor (111) and performs the following steps:

- determining (S302) a variation in ambient temperature of said oscillator over a predetermined time range thanks to measurements by said sensor; and
- adjusting (S303) a frequency, or a rate, of access to the external time or frequency reference so as to obtain said time or respectively frequency information for adjusting the oscillation frequency of said oscillator, according to the determined variation in temperature.

2. Method according to claim 1, **characterised in that**, thermal insulation being achieved thanks to a first cap (150) covering said oscillator on a printed circuit board (160) in which holes (170) are provided around said oscillator and a second cap (151) covering the opposite face of the printed circuit board, said device determines the variation in ambient temperature of said oscillator thanks also to a transfer function of said thermal insulation.

3. Method according to any one of claims 1 and 2, **characterised in that** the external time reference is implemented by a time server (121).

4. Method according to claim 3, **characterised in that**, several levels of variation in ambient temperature of said oscillator being defined, each level being associated with at least one respective sliding window, each sliding window being associated with at least one ambient temperature variation threshold enabling passing from one level to another, each level further being associated with a frequency or rate of access to the external time reference, the device performs the following steps:

- determining (S404, S408) whether the variation in ambient temperature on each sliding window of a first ambient temperature variation level passes one threshold associated with said sliding window;
- changing (S406, S410) for a second level when said threshold is passed, and applying the frequency or rate of access to the external time reference that is associated with said second level.

5. Method according to claim 4, **characterised in that** two sliding windows are defined per ambient temperature variation level.

6. Method according to any one of claims 4 to 5, **characterised in that** separate levels of variation in ambient temperature of said oscillator are defined for a transient mode and a steady mode of said device.

7. Method according to any one of claims 4 to 6, **characterised in that**, when passing from the first level to the second level, the device transfers to each sliding window of said second level some of the ambient temperature variations detected during each sliding window of the first level.

8. Method according to any one of claims 4 to 7, **characterised in that**, each ambient temperature variation level being associated with a precision of oscillation frequency of said oscillator, the device being a femto, the device performs the following steps:

- detecting a base station (130) managing a cell adjacent to the femtocell managed by the femto with better precision than that of the ambient temperature variation level in which the device happens to be;
- awaiting an absence of communication in the femtocell, and then listening out for the base station (S504) so as to obtain the frequency information for adjusting the oscillation frequency of said oscillator.

9. Method according to claim 8, **characterised in that** the device selects said base station so as to adjust the oscillation frequency of said oscillator in each of the following cases:

- the difference between the determined ambient temperature variation and each ambient temperature variation threshold associated with the sliding window of the ambient temperature variation level in which the device happens to be is lower than a predefined margin;
- the precision of the base station is better than the precision corresponding to the lower level of ambient temperature variation compared with the ambient temperature variation level in which the device happens to be, and the determined ambient temperature variation is below a high threshold of temperature variation associated with the sliding window or windows of said lower level.

10. Method according to any one of claims 8 and 9, **characterised in that** the device performs the following steps:

- translating the precision of the base station into a corresponding variation in ambient temperature; and
- reinitialising (S506) each sliding window and adding to each sliding window said corresponding variation in ambient temperature.

11. Method according to any one of claims 1 and 2, **characterised in that**, said device being a femto, the external frequency reference is implemented by a base station (130) managing a cell adjacent to the femtocell managed by the femto.

12. Device (110) comprising a voltage-control and temperature-compensated oscillator (113), the device being adapted for accessing an external time or frequency reference and for adjusting the oscillation frequency of said oscillator according to time or respectively frequency information supplied by said external time or frequency reference, further comprises:

- a sensor (111) for the ambient temperature of the oscillator;
- means for determining (S302) a variation in ambient temperature of said oscillator over a predetermined time range thanks to measurements by said sensor; and
- means for adjusting (S303) a frequency, or rate, of access to the external time or frequency reference so as to obtain said time or respectively frequency information for adjusting the oscillation frequency of said oscillator, according to the determined variation in temperature.

13. Device according to claim 12, **characterised in that** it comprises a printed circuit board (160) in which holes (170) are provided around said oscillator, a first cap (150) covering said oscillator on the printed circuit board and a second cap (151) covering the opposite face of the printed circuit board so as to produce thermal insulation, said device comprises means for determining the variation in ambient temperature of said oscillator thanks also to a transfer function of said thermal insulation.

Fig. 1A

Fig. 1B

113

150

160

170

151

Fig. 1C

| | | |
|---|---|---|
| **200**<br>CPU | **201**<br>RAM | **202**<br>ROM |

210

| | |
|---|---|
| **203** | **204** |

**110**

Fig. 2

S301

Obtention de mesures de la température ambiante du VCTCXO sur une plage temporelle

S302

Détermination d'une variation de la température ambiante du VCTCXO sur la plage temporelle

S303

Ajustement d'une fréquence d'accès à une référence temporelle ou fréquentielle externe pour ajuster la fréquence du VCTCXO

Fig. 3

S401

Définition de première et seconde fenêtres glissantes et de seuils associés

S402

Obtention de mesures de la température ambiante du VCTCXO

S403

Comparaison d'une variation de température, sur la première fenêtre glissante, avec les seuils associés

non / Seuil franchi? / oui

S404

S405

Ajustement d'une fréquence d'accès à une référence temporelle externe pour ajuster la fréquence du VCTCXO

Redéfinition des premières et secondes fenêtres glissantes et des seuils associés

S406

Comparaison d'une variation de température, sur la seconde fenêtre glissante, avec les seuils associés

S407

non / Seuil franchi ? / oui

S408

S409

Ajustement d'une fréquence d'accès à une référence temporelle externe pour ajuster la fréquence du VCTCXO

Redéfinition des premières et secondes fenêtres glissantes et des seuils associés

S410

Fig. 4

Début ~ S501

Assistance BTS activée ?    oui    non ~ S502

Critères OK ?    non    S503    oui

Ecoute de BTS    S504

Recalage en fréquence du VCTCXO ~ S505

Réinitialisation des premières et secondes fenêtres glissantes ~ S506

**Fig. 5**

Régime transitoire: définition de premiers paramètres de fenêtres et de premiers débits ~ S601

Fin de régime transitoire ?    non    oui    S602

Régime établi: définition de seconds paramètres de fenêtres et de seconds débits ~ S603

**Fig. 6**

**EP 2 997 661 B1**

## RÉFÉRENCES CITÉES DANS LA DESCRIPTION

**Documents brevets cités dans la description**

• EP 0483090 A